# EUROPÄISCHE PATENTSCHRIFT

(11) **EP 1 059 671 B1**
(45) Veröffentlichungstag und Bekanntmachung des Hinweises auf die Patenterteilung: **04.02.2009**
(21) Anmeldenummer: 00201997.4
(22) Anmeldetag: 02.06.2000
(51) Int. Cl.: H01L 27/146, G01T 1/29, H01L 31/0216, H01L 31/115

(54) **Röntgenstrahlbildsensor**
X-ray image sensor
Decteur d'images radiologiques

(30) Priorität: 11.06.1999 DE 19926582
(43) Veröffentlichungstag der Anmeldung: 13.12.2000
(73) Patentinhaber: Philips Intellectual Property & Standards GmbH, 20099 Hamburg (DE); Koninklijke Philips Electronics N.V., 5621 BA Eindhoven (NL)
(72) Erfinder: Brauers, Andreas, 52064 Aachen (DE); Schiebel, Ulrich, 52064 Aachen (CH)
(74) Vertreter: Maiwald Patentanwalts GmbH

(56) Entgegenhaltungen:
- US-A- 5 227 635
- US-A- 5 336 890
- US-A- 5 424 565
- US-A- 5 729 021

## Beschreibung

Die Erfindung betrifft einen Sensor, umfassend eine Bezugselektrode sowie eine Vielzahl von Sensorelementen, wobei jedes Sensorelement eine Sammelelektrode und eine Photoleiterstruktur umfaßt, die zwischen der Bezugselektrode und den Sammelelektroden angeordnet ist, sowie ein Schaltelement, das die Sammelelektrode mit einer Ausleseleitung verbindet, wobei die Sensorelemente in einer Matrix mit n Zeilen und m Spalten mit n, m größer 1 angeordnet sind. Zudem betrifft die Erfindung ein Röntgenstrahluntersuchungsgerät, umfassend eine Röntgenstrahlquelle zum Aussenden eines Röntgenstrahlbündels zum Durchleuchten eines Objekts zur Bildung eines Röntgenbildes sowie einen Detektor zum Erzeugen eines elektrischen Bildsignals von diesem Röntgenstrahlbild.

Ein gattungsgemäßer Sensor ist aus der WO 97/10616 bekannt. Der bekannte Röntgenstrahlbildsensor umfaßt eine Matrix aus einer Vielzahl von für Röntgenstrahlung empfindlichen Sensorelementen, die in Zeilen und Spalten angeordnet sind. Jedes Sensorelement setzt sich aus einer Sammelelektrode, einer einzeiligen Photoleiterstruktur und einer gemeinsamen Bezugselektrode zusammen.. In der Photoleiterschicht, die aus Selen (Se) oder aus Bleioxid (PbO) besteht, wird einfallende Röntgenstrahlung absorbiert, und es werden Elektronen-Lochpaare erzeugt. Unter dem Einfluß eines statischen elektrischen Feldes, das über die Photoleiterschicht zwischen der Bezugselektrode und den Sammelelektroden angelegt wird, wandern die Löcher zu der Bezugselektrode und die Elektronen werden an den Sammelelektroden gesammelt oder umgekehrt, jeweils in Abhängigkeit der Polarisierung der Elektroden. Jede Sammelelektrode ist mit einem Schaltelement verbunden. Um die angesammelten Ladungen zu lesen, werden die Schaltelemente geöffnet und die gesammelte Ladung zu entsprechenden Ausleseleitungen geleitet, von denen sie in entsprechende Verstärker fließen, die anschließend ein Ladungssignal zu einem Multiplexer geben, der die Ladungssignale der entsprechenden Ausleseleitungen in ein elektronisches Signal umwandelt.

Bei einer derartigen Sensormatrix arbeiten die Sensorelemente, die sich am Rand der Matrix befinden, nicht immer störungsfrei. Zum einen grenzt die Photoleiterstruktur, da die benachbarten Sensorelemente auf einer Seite fehlen, an die Atmosphäre, wobei sich Feuchte und Sauerstoff negativ auf die Schichtmaterialien wie Seien oder PbO auswirken. Zum anderen entstehen unerwünschte Signalbeiträge aufgrund eines kapazitiven Einkoppelns in die mit den Sammelelektroden verbundenen Auslese- und Adressleitungen, wenn sich die Photoleiterstruktur und/oder die Bezugselektrode über die aktive Bildfläche hinaus erstrecken. Die Folge ist ein unerwünschtes Rauschen.

Hiervon ausgehend ist es Aufgabe der vorliegenden Erfindung, ein störungsfreies Arbeiten auch der Sensorelemente in Matrixrandlage unabhängig von dem Randaufbau der Photoleiterstruktur und Bezugselektrode zu erreichen.

Diese Aufgabe wird mittels eines Sensors gelöst, der dadurch gekennzeichnet ist, daß die Matrix mit einem Guardelektrodenrahmen versehen ist, der zwischen der Ausleseleitung und der Photoleiterstruktur der Sensorelemente, die den Rand der Matrix bilden, angeordnet ist und der sich über den Rand der Photoleiterstruktur, d.h. über den Rand der aktiven Bildfläche, hinaus erstreckt.

Nach einer ersten Ausführungsform setzt sich der Guardelektrodenrahmen aus vorzugsweise einer oder mehreren großflächigen Guardelektroden zusammen. Die Lösung mit einer großflächigen Guardelektrode bietet Vorteile hinsichtlich der technischen Herstellung. Der Gesamtrahmen kann sich auch aus mehreren, beispielsweise zwei Teilrahmen zusammensetzen.

Nach einer zweiten Ausführungsform setzt sich der Guardelektrodenrahmen aus so vielen einzelnen Guardelektroden zusammen, daß jedes Sensorelement, das den Rand der Matrix bildet, mit einer Guardelektrode versehen ist.

Aufgrund des erfindungsgemäß vorgeschlagenen Guardelektrodenrahmens werden Störungen in Form von parasitären Kapazitäten zwischen der Bezugselektrode und den Ausleseleitungen im sinne einer Abschirmung bei nicht idealem Randschichtaufbau der Photoleiterstruktur und Bezugselektrode unterdrückt.
Zudem kann die Photoleiterstruktur sogar über die aktive Bildfläche hinaus, beispielsweise durch ein stufiges Aufeinanderanordnen von mehreren Schichten, aufgebracht werden. Dies hat den Vorteil, daß herstellungsbedingte Materialinhomogenitäten am Rand der einzelnen Schichten der Photoleiterstruktur aus der aktiven Bildfläche herausfallen und nicht zu Bildstörungen fuhren. Ferner ist der stufenweise Aufbau einer mehrschichtigen Photoleiterstruktur technologisch einfacher zu realisieren als ein idealer vertikaler Schnitt.

Vorzugsweise ist die Guardelektrode auf einem der Sammelelektrode entsprechenden Schichtniveau angeordnet. Dies ermöglicht, daß der Guardelektrodenrahmen und die Sammelelektrode während des gleichen Prozeßschritts im Herstellungsverfahren mit der Dünnfilmtechnik aufgebracht werden können.

Vorzugsweise ist der Randbereich der Photoleiterstruktur der Sensorelemente, die den Rand der Matrix bilden, mit einer feuchtigkeits- und luftundurchlässigen Passivierungsschicht versehen und steht sich die Photoleiterstruktur aus mindestens zwei übereinander angeordneten Photoleiterschichten aus unterschiedlichem Material zusammen, wobei als Material einer Schicht Bleioxid und als Material einer zweiten Schicht Selen gewählt ist.

Erfindungsgemäß wird durch Vorsehen einer Bleioxid-Schicht ein Ausgleich der sehr empfindlichen Selen-Schicht innerhalb der mehrschichtigen Photoleiter-Struktur geschaffen. Mittels der vorgeschlagenen Passivierungsschicht werden negative Einflüsse der Atmosphäre auf die Photoleiterschichten und folglich Störungseinflüsse auf die Randbereiche vermieden. Die Passivierungsschicht besteht bevorzugt aus einem Kunststoff, wie Polyethylen, Polyxylylen (unter Parylen® bekannt) oder Polyurethan besteht.

Nach einer bevorzugten Ausführungsform der Erfindung ist der Randbereich der Matrix eines gattungsgemäßen Sensors mit einer mehrschichtigen Photoleiterstruktur sowohl mit einem Guardelektrodenrahmen abgeschirmt als auch mit einer Passivierungsschicht geschützt.

Weitere Einzelheiten und Vorteile der Erfindung ergeben sich aus den Unteransprüchen und der nachfolgenden Beschreibung, in der die in den Figuren dargestellten Ausführungsbeispiele der Erfindung näher erläutert werden. Es zeigen:
- Figur 1: ein Schaltschema einer Röntgenstrahlsensormatrix gemäß der Erfindung;
- Figur 2: eine schematische Schnittansicht der Dünnfilmstruktur eines Röntgenstrahlsensors mit einem Guardelektrodenrahmen;
- Figur 3: eine schematische Schnittansicht der Dünnfilmtruktur eines mehrschichtigen Röntgenstrahlsensors mit einer Passivierungsschicht;
- Figur 4: ein Röntgenstrahluntersuchungsgerät, welches einen Röntgenstrahlsensor gemäß der Erfindung aufweist.

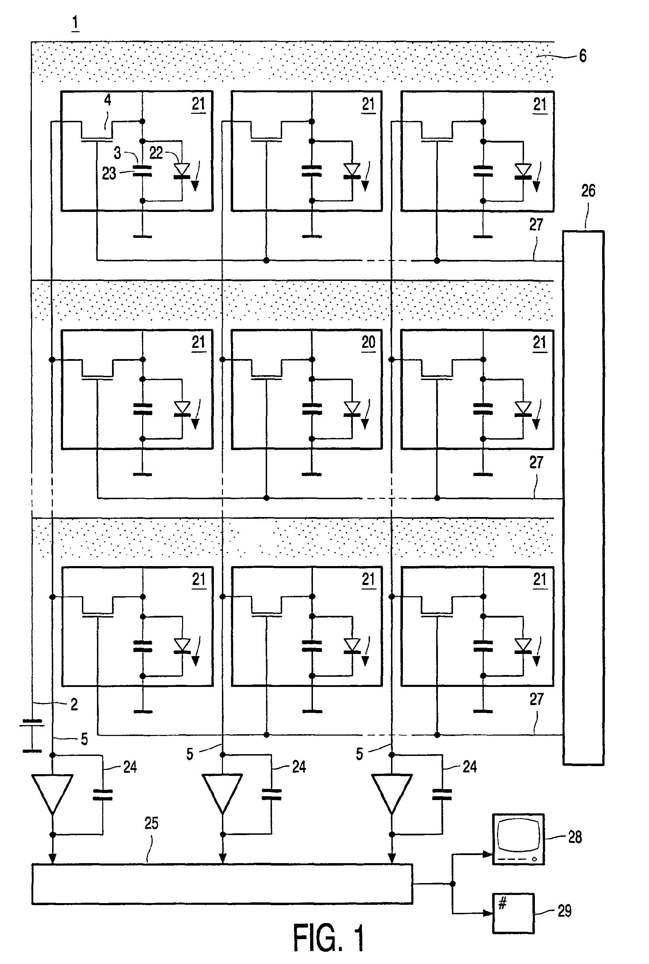

Figur 1 zeigt ein Schaltschema einer Röntgenstrahlsensormatrix 1 gemäß der Erfindung. Obwohl das Schaltschema nur drei mal drei Sensorelemente zeigt, handelt es sich bei einer praktischen Ausführung um Matrizes mit beispielsweise 2000 x 2000 Sensorelementen. Die den Rand der Matrix bildenden Sensorelemente sind mit 21, das mittig angeordnete Sensorelement mit 20 bezeichnet. Für jedes Pixel ist ein für Röntgenstrahlung empfindliches Sensorelement 21 bzw. 20 vorgesehen, das einen Photosensor 22, eine Kapazität 23 und ein Schaltelement 4 aufweist. Die Schaltelemente 4 sind vorzugsweise als TFTs (thin-film-Transistoren) ausgebildet. Einfallende Röntgenstrahlen werden mittels des Photosensors 22 in Ladungen umgewandelt, die mittels der Kapazität 23 gesammelt werden. Die Sammelelektroden 3 sind Teil der entsprechenden Kapazitäten 23. Jede Spalte der Matrix ist hier mit einer entsprechenden Ausleseleitung 5 versehen, und jede Kapazität 23 ist mit der entsprechenden Ausleseleitung 5 über ein Schaltelement 4 verbunden. Die Ausleseleitungen 5 sind mit Verstärkern 24 verbunden, die die Ausgangssignale an Multiplexer 25 weiterleiten. Die Schaltelemente 4 werden mittels einer Schaltung 26 gesteuert, die für jede Zeile mit den Schaltelementen 4 mittels Adressleitungen 27 verbunden ist.Der Multiplexer 25 liefert das elektronische Bildsignal an einen Monitor 28 oder einen Bildprozessor 29.

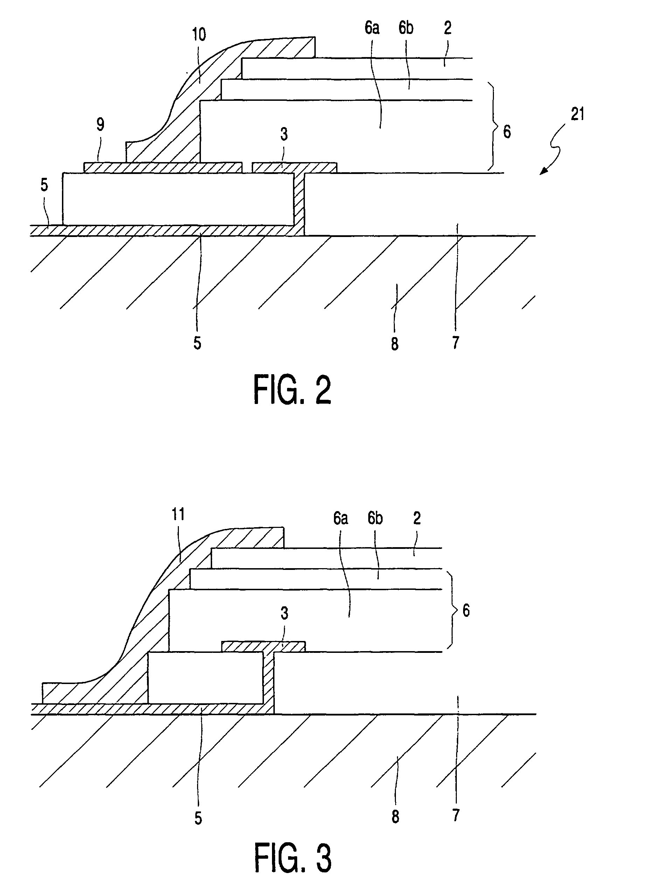

Figur 2 zeigt die schematische Dünnfilmstruktur eines Röntgenstrahlsensorelementes 21 gemäß der Erfindung im Schnitt. Es ist ein Sensorelement 21 dargestellt, welches sich am Rand der Matrix befindet. Das Sensorelement umfaßt eine Photoleiterstruktur 6, die zwischen einer allgemeinen Bezugselektrode 2 und einer Sammelelektrode 3 ausgebildet ist. Einfallende Röntgenstrahlung wird in der Photoleiterstruktur 6 absorbiert, und es werden Elektronen-Lochpaare erzeugt. Die Bezugselektrode und die Sammelelektroden funktionieren als Kathode bzw. Anode unter dem Einfluß eines angelegten elektrischen Feldes. Die Sammelelektrode 3 ist, eingebettet in eine Passivierungsschicht 7, auf einem Substrat 8, beispielsweise einer Glasschicht, angeordnet und über ein Schaltelement (nicht gezeigt) mit einer Ausleseleitung 5 verbunden.

Über der Sammelelektrode 3, die als dünne Metallschicht beispielsweise aus Gold oder Aluminium ausgebildet ist, schließt sich die Photoleiterstruktur 6 an, die mehrschichtig aufgebaut ist. Sie setzt sich aus einer ersten PbO-Schicht (6a), gefolgt von einer Schicht aus Se (6b) zusammen. Bei dem Bleioxid kann es sich um polykristallines Bleioxid (PbOₓ, 0<x≤ 2) handeln. Es schließt sich die Bezugselektrode 2 an. Die Bezugselektrode ist eine dünne Metallschicht, beispielsweise mit einer Dicke im Bereich zwischen 100nm bis 1 µm. Bei dieser Ausführungsform handelt es sich um eine Goldschicht, andere passende Schichten sind beispielsweise aus Al, Ag, Pt, Pd etc. Die Schichten 6a, 6b und 2 müssen nicht bündig am Rand abschließen, hier sind die drei Schichten stufig angeordnet.

Auf gleichen Schichtniveau mit der Sammelelektrode 3 befindet sich der Guardelektrodenrahmen 9. Dieser ist zwischen der Passivierungsschicht für die Ausleseleitung 5 und der Photoleiterstruktur 6 angeordnet. Der Guardelektrodenrahmen erstreckt sich über den Randbereich der untersten Schicht 6a der Photoleiterstruktur hinaus, liegt auf gleichem Potential wie die Ausleseleitung 5 und bildet somit eine geeignete Abschirmung zur Unterbindung von parasitären Signalen. Zudem müssen bei Vorsehen einer Guardelektrode 9 die Randschichten des Sensorelementes nicht mehr bündig abschließen, sondern können über das Pixelfeld hinaus ausgedehnt aufgebracht werden. Bei Mehrschichtstrukturen können beispielsweise die PbO-Schicht 3 mm, die Se-Schicht 2 mm und die Au-Schicht der Bezugselektrode 1 mm über das äußerste Pixel hinaus aufgebracht werden. Randeffekte der Schichten beeinflussen die Wechselwirkung zwischen der Bezugselektrode und den Sammelelektroden der Randsensorelemente nicht mehr.

Entlang der Photoleiterstruktur 6 ist auf der Guardelektrode 9 bis hin zu der Bezugselektrode 2 eine Passivierungsschicht 10 aufgebracht. Diese Passivierungsschicht 10 ist aus einem elektrisch isolierten Material wie Polyurethan oder elektrisch isolierten Harzen gebildet. Ein bevorzugtes Material ist auch Polyxylylen ((CH₂-C₆H₄-CH₂)ₙ) (Parylen®).

Figur 3 zeigt ein nicht-erfindungsgemäßes Randsensorelement mit aufgebrachter Passivierungsschicht 11 entlang einer mehrschichtigen Photoleiterstruktur 6. Teile, die Figur 2 entsprechen, sind mit gleichen Bezugsziffern versehen. Die Photoleiterstruktur 6 setzt sich aus einer untersten Schicht PbO 6a und einer darauf angeordneten Schicht Se 6b zusammen. Die feuchtigkeits- und luftundurchlässige Passivierungsschicht bildet einen Schutzrahmen für die an der Atmosphäre liegenden Bereiche der Randsensorelemente. Die Schicht 11 kann über die Bezugselektrode 2 hinaus ausgedehnt sein. In allen Fällen muß aber ein elektrischer Durchgang zur Bezugselektrode vorgesehen sein.

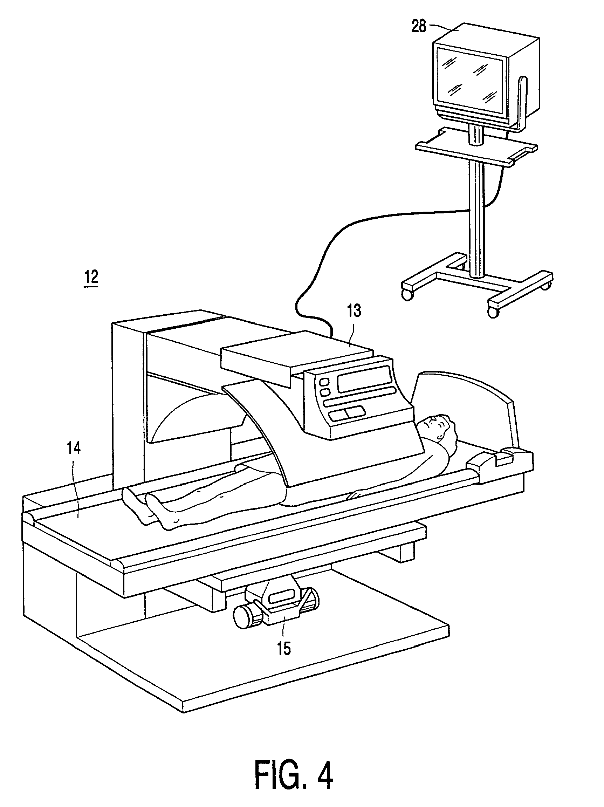

Figur 4 stellt ein Röntgensträhluntersuchungsgerät 12 dar mit einem Detektor 13, der einen Röntgenstrählsensor gemäß der Erfindung aufweist. Das Röntgenstrahluntersuchungsgerät 12 umfaßt eine Liegefläche 14 für einen Patienten. Eine Röntgenstrahlquelle 15 ist unterhalb dieser Liege vorgesehen. Der Röntgenstrahldetektor 13 ist zur Strahlungsquelle 15 verstellbar angeordnet. Um ein Röntgenbild zu erzeugen, wird der Patient mit einem Röntgenstrahl durchleuchtet. In Abhängigkeit von lokalen Unterschieden der Röntgenstrahlabsorption durch den Patienten wird ein Röntgenbild mittels des Detektors erzeugt. Mittels des Röntgenstrahlsensors wird dieses Bild in elektrische Signale umgewandelt, die dann zur Darstellung des Röntgenbildes zu dem Monitor 28 geliefert werden.

## Patentansprüche

1. Sensor, umfassend eine Bezugselektrode (2) sowie eine Vielzahl von Sensorelementen (20,21),
wobei jedes Sensorelement (20, 21) eine Sammelelektrode (3) und eine Fotoleiterstruktur (6) umfasst, die zwischen der Bezugselektrode (2) und den Sammelelektroden (3) angeordnet ist, sowie ein Schaltelement (4), das die Sammelelektrode (3) mit einer Ausleseleitung (5) verbindet, wobei die Sensorelemente (20, 21) in einer Matrix (1) mit *n* Zeilen und *m* Spalten (mit *n, m* > 1) angeordnet sind,
wobei die Matrix (1) mit einem Guardelektrodenrahmen (9) versehen ist, der zwischen der Ausleseleitung (5) und der Fotoleiterstruktur (6) der Sensorelemente (21), die den Rand der Matrix (1) bilden, angeordnet ist und der sich über den Rand der Fotoleiterstruktur (6) hinaus erstreckt.

2. Sensor nach Anspruch 1,
wobei sich der Guardelektrodenrahmen (9) aus einer oder mehreren großflächigen Guardelektroden zusammensetzt.

3. Sensor nach Anspruch 1,
wobei sich der Guardelektrodenrahmen (9) aus mehreren Guardelektroden zusammensetzt, so dass jedem Sensorelement (21), das den Rand der Matrix (1) bildet, jeweils eine Guardelektrode zugeordnet ist.

4. Sensor nach Anspruch 1,
wobei der Guardelektrodenrahmen (9) auf einem der Sammelelektrode (3) entsprechenden Schichtniveau angeordnet ist.

5. Sensor nach Anspruch 1,
wobei der Randbereich der Fotoleiterstruktur (6) der Sensorelemente (21), die den Rand der Matrix (1) bilden, mit einer feuchtigkeits- und luftundurchlässigen Passivierungsschicht (10) versehen ist und die Fotoleiterstruktur (6) sich aus mindestens zwei übereinander angeordneten Fotoleiterschichten (6a, 6b) aus unterschiedlichem Material zusammensetzt, wobei als Material einer Schicht (6a) Bleioxid und als Material einer zweiten Schicht (6b) Selen gewählt ist.

6. Sensor nach Anspruch 5,
wobei sich die Passivierungsschicht (10) von dem Guardelektrodenrahmen (9) über die Fotoleiterstruktur (6) bis zur Bezugselektrode (2) erstreckt.

7. Sensor nach Anspruch 6,
wobei sich die Passivierungsschicht (10) teilweise oder vollständig über die Bezugselektrode (2) erstreckt.

8. Sensor nach einem der vorherigen Ansprüche,
wobei es sich um einen Röntgenbildsensor handelt.

9. Röntgenstrahluntersuchungsgerät (12), umfassend eine Röntgenstrahlquelle (15) zum Aussenden eines Röntgenstrahlbündels zum Durchleuchten eines Objekts zur Bildung eines Röntgenbildes sowie einen Detektor (13) zum Erzeugen eines elektrischen Bildsignals von diesem Röntgenstrahlbild,
wobei der Röntgenstrahldetektor (13) einen Sensor nach den Ansprüchen 1 bis 8 umfasst.

## Claims

1. A sensor which includes a reference electrode (2) as well as a plurality of sensor elements (20, 21), each sensor element (20, 21) including a collector electrode (3) and a photoconductor structure (6) which is arranged between the reference electrode (2) and the collector electrodes (3), as well as a switching element (4) which connects the collector electrode (3) to a read-out lead (5), the sensor elements (20, 21) being arranged in a matrix (1) of n rows and m columns (where n, m > 1),
wherein the matrix (1) is provided with a guard electrode window (9) which is arranged between the read-out lead (5) and the photoconductor structure (6) of the sensor elements (21) constituting the edge of the matrix (1) and extends beyond the edge of the photoconductor structure (6).

2. A sensor as claimed in Claim 1,
wherein the guard electrode window (9) is composed of one or more large-area guard electrodes.

3. A sensor as claimed in Claim 1,
wherein the guard electrode window (9) consists of a plurality of guard electrodes so that with each sensor element (21) constituting the edge of the matrix (1) there is associated a respective guard electrode.

4. A sensor as claimed in Claim 1,
wherein the guard electrode window (9) is arranged at a layer level corresponding to the collector electrode (3).

5. A sensor as claimed in Claim 1,
wherein the edge zone of the photoconductor structure (6) of the sensor elements (21) constituting the edge of the matrix (1) is provided with a passivation layer (10) which is impermeable to moisture and air, and the photoconductor structure (6) is composed of at least two photoconductor layers (6a, 6b) of a different material which are arranged one above the other, the material chosen for one layer (6a) being lead oxide and the material chosen for a second layer (6b) being selenium.

6. A sensor as claimed in Claim 5,
wherein, from the guard electrode window (9) the passivation layer (10) extends across the photoconductor structure (6) as far as the reference electrode (2).

7. A sensor as claimed in Claim 6,
wherein the passivation layer (10) extends partly or completely across the reference electrode (2).

8. A sensor as claimed in any one of the preceding Claims,
wherein an X-ray image sensor is concerned.

9. An X-ray examination apparatus (12), including an X-ray source (15) for emitting an X-ray beam for irradiating an object so as to form an X-ray image, as well as a detector (13) for generating an electrical image signal from said X-ray image,
wherein the X-ray detector (13) includes a sensor as claimed in any one of the Claims 1 to 8.

## Revendications

1. Capteur comprenant une électrode de référence (2) ainsi qu'une multitude d'éléments capteurs (20, 21), chaque élément capteur (20, 21) comprenant une électrode collectrice (3) et une structure photoconductrice (6) qui est disposée entre l'électrode de référence (2) et les électrodes collectrices (3), ainsi qu'un élément commutateur (4) qui relie l'électrode collectrice (3) avec une ligne de lecture (5), les éléments capteurs (20, 21) étant disposés dans une matrice (1) avec *n* lignes et *m* colonnes (avec *n, m >* 1), la matrice (1) étant dotée d'un cadre d'électrodes de garde (9) qui est disposé entre la ligne de lecture (5) et la structure photoconductrice (6) des éléments capteurs (21) qui forment le bord de la matrice (1) et s'étend au-delà du bord de la structure photoconductrice (6).

2. Capteur selon la revendication 1,
le cadre des électrodes de garde (9) se composant d'une ou plusieurs électrodes de garde de grande surface.

3. Capteur selon la revendication 1,
le cadre des électrodes de garde (9) se composant de plusieurs électrodes de garde de telle sorte qu'une électrode de garde soit respectivement attribuée à chaque élément capteur (21) qui forme le bord de la matrice (1).

4. Capteur selon la revendication 1,
le cadre des électrodes de garde (9) étant disposé sur un niveau de couche correspondant à l'électrode collectrice (3).

5. Capteur selon la revendication 1,
la zone de bordure de la structure photoconductrice (6) des éléments capteurs (21) qui forment le bord de la matrice (1) étant dotée d'une couche de passivation (10) imperméable à l'humidité et à l'air et la structure photoconductrice (6) se composant d'au moins deux couches photoconductrices (6a, 6b) superposées d'un matériau différent, l'oxyde de plomb étant utilisé comme matériau d'une couche (6a) et le sélénium étant choisi comme matériau d'une deuxième couche (6b).

6. Capteur selon la revendication 5,
dans lequel la couche de passivation (10) s'étend du cadre des électrodes de garde (9) à l'électrode de référence (2) en passant par la structure photoconductrice (6).

7. Capteur selon la revendication 6,
la couche de passivation (10) s'étendant en tout ou en partie sur l'électrode de référence (2).

8. Capteur selon l'une des revendications précédentes, qui est un capteur d'images radiographiques.

9. Appareil d'examen radiographique (12) comprenant une source de rayons X (15) pour la transmission d'un faisceau de rayons X pour l'exposition d'un objet en vue de la formation d'une image radiographique ainsi qu'un détecteur (13) pour la production d'un signal d'image électrique par cette image radiographique,
le détecteur de rayons X (13) comprenant un capteur selon l'une des revendications 1 à 8.
